# EUROPÄISCHE PATENTSCHRIFT

(11) **EP 4 409 630 B1**
(45) Veröffentlichungstag und Bekanntmachung des Hinweises auf die Patenterteilung: **10.12.2025**
(21) Anmeldenummer: 22789609.9
(22) Anmeldetag: 30.09.2022
(51) Int. Cl.: H01L 23/373, C04B 37/02

(54) **METALL-KERAMIK-SUBSTRAT UND VERFAHREN ZUR HERSTELLUNG EINES METALL-KERAMIK-SUBSTRATS**
METAL-CERAMIC SUBSTRATE AND METHOD FOR PRODUCING A METAL-CERAMIC SUBSTRATE
SUBSTRAT MÉTAL-CÉRAMIQUE ET PROCÉDÉ DE FABRICATION D'UN SUBSTRAT MÉTAL-CÉRAMIQUE

(30) Priorität: 01.10.2021 DE 102021125557
(43) Veröffentlichungstag der Anmeldung: 07.08.2024
(73) Patentinhaber: Rogers Germany GmbH, 92676 Eschenbach (DE)
(72) Erfinder: MEYER, Andreas, 95469 Speichersdorf (DE)
(74) Vertreter: Müller Schupfner & Partner Patent- und Rechtsanwaltspartnerschaft mbB (Muc)
(86) Internationale Anmeldenummer: PCT/EP2022/077292
(87) Internationale Veröffentlichungsnummer: WO 2023/052589

(56) Entgegenhaltungen:
- EP-A1- 2 827 364
- EP-B1- 1 487 759
- EP-B1- 2 911 994
- DE-A1- 102012 103 786
- DE-A1- 102019 135 146
- JP-A- 2013 175 525
- JP-A- H03 145 748
- JP-A- H08 250 823
- JP-A- S6 459 986

## Beschreibung

Die vorliegende Erfindung betrifft ein Metall-Keramik-Substrat und ein Verfahren zur Herstellung eines Metall-Keramik-Substrats.

Trägersubstrate für elektrische Bauteile, beispielsweise in Form von Metall-Keramik-Substraten, sind beispielsweise als Leiterplatten oder Platinen aus dem Stand der Technik hinlänglich bekannt, beispielsweise aus der DE 10 2013 104 739 A1, der DE 19 927 046 B4 und der DE 10 2009 033 029 A1. Typischerweise werden auf einer Bauteilseite des Metall-Keramik-Substrats Anschlussflächen für elektrische Bauteile und Leiterbahnen angeordnet, wobei die elektrischen Bauteile und Leiterbahnen zu elektrischen Schaltkreisen zusammenschaltbar sind. Wesentliche Bestandteile der Metall-Keramik-Substrate sind eine Isolationsschicht, die bevorzugt aus einer Keramik gefertigt ist, und eine an die Isolationsschicht angebundene Bauteilmetallisierung bzw. Bauteilmetallisierung. Wegen ihren vergleichsweise hohen Isolationsfestigkeiten haben sich aus Keramik gefertigte Isolationsschichten in der Leistungselektronik als besonders vorteilhaft erwiesen. Durch eine Strukturierung der Bauteilmetallisierung können sodann Leiterbahnen und/oder Anschlussflächen für die elektrischen Bauteile realisiert werden.

Zur Anbindung von Bauteilmetallisierungen an das Keramikelement ist es üblicherweise vorgesehen, ein Hochtemperaturverfahren, wie beispielsweise ein heißisostatisches Pressen, ein Diffusionsanbindungsverfahren, ein Direktmetallanbindungsverfahren, ein DCB-Verfahren oder ein Aktivlötverfahren zu verwenden. Zur Ausbildung von einzelnen Leiterbahnen bzw. Anschlussflächen wird die angebundenen Bauteilmetallisierung strukturiert, so dass in der Bauteilmetallisierung zumindest ein erster Metallabschnitt und ein zweiter Metallabschnitt entstehen, die voneinander separiert und isoliert sind. Da die Bauteilmetallisierung und das Keramikelement unterschiedliche Ausdehnungskoeffizienten haben, entwickeln sich in der Bindungsschnittstelle zwischen Bauteilmetallisierung und Keramikelement bei Temperaturentwicklungen, die beispielsweise beim Anbinden oder durch elektrische Bauteile entstehen, thermomechanische Spannungen, die dazu führen, dass das gesamte Metall-Keramik-Substrat eine Durchbiegung erfahren kann. Um diesem Effekt entgegenzuwirken, sieht es der Stand der Technik vor, eine Rückseitenmetallisierung an das Keramikelement anzubinden, um eine Symmetrie zwischen Bauteilseite und Rückseite des Metall-Keramik-Substrats zu schaffen.

Aus der DE 10 2019 135 146 A1 ist ein Metall-Keramik-Substrat bekannt, das eine Bauteilmetallisierung und eine Rückseitenmetallisierung aufweist, die an gegenüberliegenden Seiten an dasselbe Keramikelement angebunden sind. Ferner sind Ausnehmungen in der Bauteilmetallisierung und der Rückseitenmetallisierung ausgebildet. Weitere Trägersubstrate findet man in EP 2 827 364 A1, EP 1 487 759 A1, EP 2 911 994 A1, JP H08 250 823 A und JP 2013 175 525 A.

Ausgehend vom Stand der Technik macht es sich die vorliegende Erfindung zur Aufgabe, Metall-Keramik-Substrate dahingehend zu verbessern, dass ihre Anfälligkeit für ein Durchbiegen weiter reduziert wird und möglichst ebene Metall-Keramik-Substrate bereitgestellt werden.

Die vorliegende Erfindung löst diese Aufgabe mit einem Metall-Keramik-Substrat gemäß Anspruch 1 bzw. 10 und einem Verfahren zum Herstellen eines Metall-Keramik-Substrats gemäß Anspruch 11.

Gemäß einem ersten Aspekt ist ein Metall-Keramik-Substrat vorgesehen, das als Leiterplatte zum Befestigen von elektrischen Bauteilen vorgesehen bzw. bestimmt ist, umfassend:
- eine Bauteilmetallisierung und eine Rückseitenmetallisierung und
- ein Keramikelement, das entlang einer Stapelrichtung zwischen der Bauteilmetallisierung und der Rückseitenmetallisierung angeordnet ist,
wobei die Bauteilmetallisierung einen ersten Metallabschnitt und einen zweiten Metallabschnitt aufweist, wobei der erste Metallabschnitt und der zweite Metallabschnitt durch einen Isolationsabschnitt voneinander getrennt sind, und wobei die Rückseitenmetallisierung eine Materialschwächung, insbesondere eine Materialaussparung, aufweist, die in Stapelrichtung gesehen deckungsgleich zum Isolationsabschnitt angeordnet ist.

Im Gegensatz zu den aus dem Stand der Technik bekannten Metall-Keramik-Substraten ist es vorgesehen, dass die Rückseitenmetallisierung Materialschwächungen aufweist, die genau so angeordnet sind, dass sie deckungsgleich zu dem Isolationsabschnitt oder den Isolationsabschnitten auf der Bauteilseite angeordnet sind bzw. verlaufen. Dadurch wird in vorteilhafter Weise die Symmetrie der Materialverteilung auf der Bauteilseite und der gegenüberliegenden Rückseite erhöht. Dies führt im Ergebnis dazu, dass die Anfälligkeit für ein Durchbiegen des Gesamtsubstrats reduziert werden kann, da die auf der Bauteilseite und der Rückseite auftretenden thermomechanischen Spannungen sich gegenseitig kompensieren. Somit lässt sich die Neigung zur Verbiegung weiter reduzieren und es können möglichst ebene Metall-Keramik-Substrate bereitgestellt werden. Hierzu ist es bevorzugt vorgesehen, dass eine erste Dicke der Bauteilmetallisierung im Wesentlichen einer zweiten Dicke der Rückseitenmetallisierung entspricht.

Unter einer deckungsgleichen Anordnung ist insbesondere zu verstehen, dass im Falle der gedachten Projektion der Materialschwächung entlang der Stapelrichtung bzw. entlang einer parallel zur Stapelrichtung verlaufenden Richtung ein räumlicher Überlapp mit dem Isolationsabschnitt festzustellen wäre. Dabei erfolgt dieser gedachte räumliche Überlapp für mehr als 50%, bevorzugt mehr als 75% und besonders bevorzugt für mehr als 90% der Ausdehnung der Materialschwächung in der Rückseitenmetallisierung. Dabei kann die Mitte der Ausdehnung der Materialschwächung im Wesentlichen deckungsgleich zu der Mitte der Ausdehnung des Isolationsabschnitts angeordnet sein oder dazu seitlich, d. h. entlang einer senkrecht zur Stapelrichtung verlaufenden Richtung, versetzt sein.

Weiterhin ist es bevorzugt vorgesehen, dass das Keramikelement eine entlang der Stapelrichtung gemessene dritte Dicke aufweist. Dabei ist es besonders bevorzugt vorgesehen, dass die dritte Dicke kleiner als 700 µm ist, bevorzugt kleiner als 400 µm und besonders bevorzugt kleiner als 330 µm. Die Symmetrie zwischen den Materialschwächungen in der Rückseitenmetallisierung und den Isolationsabschnitten in der Bauteilmetallisierung erweist sich insbesondere für vergleichsweise dünne Isolationsschichten bzw. Keramikelemente als Vorteil, weil diese Keramikelemente besonders anfällig sind gegenüber Verbiegungen und sogar einem Brechen. Beispielsweise ist es sogar vorstellbar, dass die dritte Dicke des Keramikelements kleiner ist bzw. dünner ist als jeweils die erste Dicke der Bauteilmetallisierung und die zweite Dicke der Rückseitenmetallisierung oder die Summe aus der ersten Dicke und der zweiten Dicke.

Ferner ist es vorzugsweise vorgesehen, dass die Strukturierung und/oder das Einlassen der Materialschwächung nach dem Anbinden der Metallisierung und/oder Rückseitenmetallisierung an das Keramikelement durchgeführt wird.

Insbesondere handelt es sich um ein Metall-Keramik-Substrat, das als Leiterplatte verwendet wird, bei dem an der Bauteilseite eine Metallisierung, d. h. eine Bauteilmetallisierung, ausgebildet wird, die aufgrund der Strukturierung mehrere voneinander elektrisch isolierte Metallisierungsabschnitte aufweist. Diese Metallisierungsabschnitte bilden beispielsweise Anschlussflächen oder Pads bzw. Leiterbahnen der Leiterplatte.

Vorzugsweise weist das Keramikelement Al₂O₃, Si₃N₄, AIN, eine HPSX-Keramik (d. h. eine Keramik mit einer Al₂O₃- Matrix, die einen x-prozentigen Anteil an ZrO₂ umfasst, beispielsweise Al₂O₃ mit 9% ZrO₂ = HPS9 oder Al₂O₃ mit 25% ZrO₂ = HPS25), SiC, BeO, MgO, hochdichtes MgO (> 90% der theoretischen Dichte), TSZ (tetragonal stabilisiertes Zirkonoxid) als Material für die Keramik auf. Es ist dabei auch vorstellbar, dass das Keramikelement als Verbund- bzw. Hybridkeramik ausgebildet ist, bei der zur Kombination verschiedener gewünschter Eigenschaften mehrere Keramikschichten, die sich jeweils in Hinblick auf ihre materielle Zusammensetzung unterscheiden, übereinander angeordnet und zu einem Isolationselement zusammengefügt sind.

Als Materialien für die Bauteilmetallisierung und/oder Rückseitenmetallisierung sind Kupfer, Aluminium, Molybdän, Wolfram und/oder deren Legierungen wie z. B. CuZr, AlSi oder AlMgSi, sowie Laminate wie CuW, CuMo, CuAl und/oder AlCu oder MMC (metal matrix composite), wie CuW, CuMo oder AlSiC, vorstellbar. Vorzugsweise entspricht die Bauteilmetallisierung der Rückseitenmetallisierung in Hinblick auf sein Material oder unterscheidet sich. Weiterhin ist bevorzugt vorgesehen, dass die Bauteilmetallisierung und/oder die Rückseitenmetallisierung am gefertigten Metall-Keramik-Substrat, insbesondere als Bauteilmetallisierung, oberflächenmodifiziert ist. Als Oberflächenmodifikation ist beispielsweise eine Versiegelung mit einem Edelmetall, insbesondere Silber; und/oder Gold, oder (electroless) Nickel oder ENIG ("*electroless nickel immersion gold*") oder ein Kantenverguss an der Metallisierung zur Unterdrückung einer Rissbildung bzw. -weitung denkbar. Beispielsweise unterscheidet sich auch das Metall der Bauteilmetallisierung von dem Metall der Rückseitenmetallisierung.

Die Anbindung der Metallschicht, d. h. die Bauteilmetallisierung und/oder die Rückseitenmetallisierung, an das Keramikelement kann beispielsweise über ein DCB-Verfahren, ein AMB-Verfahren, ein Diffusionsbonden, insbesondere ADB, und/oder ein heißisostatisches Pressen erfolgen.

Unter einem "DCB-Verfahren" (Direct-Copper-Bond-Technology) oder einem "DAB-Verfahren" (Direct-Aluminium-Bond-Technology) versteht der Fachmann ein solches Verfahren, das beispielsweise zum Verbinden von Metallschichten oder - blechen (z. B. Kupferblechen oder -folien oder Aluminiumblechen oder -folien) miteinander und/oder mit Keramik oder Keramikschichten dient, und zwar unter Verwendung von Metall- bzw. Kupferblechen oder Metall- bzw. Kupferfolien, die an ihren Oberflächenseiten eine Schicht oder einen Überzug (Aufschmelzschicht), aufweisen. Bei diesem beispielsweise in der US 3 744 120 A oder in der DE23 19 854 C2 beschriebenen Verfahren bildet diese Schicht oder dieser Überzug (Aufschmelzschicht) ein Eutektikum mit einer Schmelztemperatur unter der Schmelztemperatur des Metalls (z. B. Kupfers), so dass durch Auflegen der Folie auf die Keramik und durch Erhitzen sämtlicher Schichten diese miteinander verbunden werden können, und zwar durch Aufschmelzen des Metalls bzw. Kupfers im Wesentlichen nur im Bereich der Aufschmelzschicht bzw. Oxidschicht.

Vorzugsweise erfolgt das Verbinden der Keramikschicht und der Metallschicht mittels eines Direktmetallanbindungsverfahrens, eines heißisostatischen Pressens, eines Lötverfahrens und/oder eines Diffusionsbondprozess.

Insbesondere weist das DCB-Verfahren dann z. B. folgende Verfahrensschritte auf:
- Oxidieren einer Kupferfolie derart, dass sich eine gleichmäßige Kupferoxidschicht ergibt;
- Auflegen des Kupferfolie auf die Keramikschicht;
- Erhitzen des Verbundes auf eine Prozesstemperatur zwischen etwa 1025 bis 1083°C, z. B. auf ca. 1071°C;
- Abkühlen auf Raumtemperatur.

Unter einem Aktivlot-Verfahren, z. B. zum Verbinden von Metallschichten oder Metallfolien, insbesondere auch von Kupferschichten oder Kupferfolien mit Keramikmaterial ist ein Verfahren zu verstehen, welches speziell auch zum Herstellen von Metall-Keramik-Substraten verwendet wird, wird bei einer Temperatur zwischen ca. 600-1000°C eine Verbindung zwischen einer Metallfolie, beispielsweise Kupferfolie, und einem Keramiksubstrat, beispielsweise Aluminiumnitrid-Keramik, unter Verwendung eines Hartlots hergestellt, welches zusätzlich zu einer Hauptkomponente wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlöt-Verbindung ist. Alternativ ist zur Anbindung auch ein Dickschichtverfahren vorstellbar.

Vorzugsweise ist als Diffusionsbondverfahren ein ADB (active diffusion bonding) - Verfahren vorgesehen, das beispielsweise die folgenden Schritte umfasst:
- Bereitstellen eines Keramikelements und einer Metallschicht,
- Bereitstellen eines gasdichten Behälters, der das Keramikelement umschließt, wobei der Behälter vorzugsweise aus der Metallschicht geformt ist oder die Metallschicht umfasst,
- Ausbilden des Metall-Keramik-Substrats durch ein Anbinden der Metallschicht an das Keramikelement mittels heißisostatischem Pressen,
wobei zum Ausbilden des Metall-Keramik-Substrats zwischen der Metallschicht und dem Keramikelement mindestens abschnittsweise eine Aktivmetallschicht oder eine ein Aktivmetall umfassende Kontaktschicht, zur Unterstützung des Anbindens der Metallschicht an das Keramikelement, angeordnet wird. Der Behälter wird dabei vorzugsweise als Metallbehälter aus einer Metallschicht und/oder einer weiteren Metallschicht gebildet. Alternativ ist es auch vorstellbar, dass ein Glasbehälter verwendet wird.

Beim heißisostatischen Pressen ist es insbesondere vorgesehen, dass das Bonden durch Erhitzen unter Druck erfolgt, bei der Metallschicht des Metallbehälters, insbesondere die spätere Metallschicht des Metall-Keramik-Substrats und eine etwaige dort auftretende eutektische Schicht nicht in die Schmelzphase übertritt. In entsprechender Weise sind beim heißisostatischem Pressen geringere Temperaturen als bei einem Direktmetallanbindungsverfahren, insbesondere einem DCB-Verfahren, erforderlich.

Im Vergleich zu der Anbindung einer Metallschicht an eine Keramikschicht mittels eines Lotmaterials, bei dem üblicherweise Temperaturen unterhalb der Schmelztemperatur der mindestens einen Metallschicht verwendet werden, kann bei der vorliegenden Vorgehensweise in vorteilhafter Weise auf ein Lotbasismaterial verzichtet werden und es wird lediglich ein Aktivmetall benötigt. Die Verwendung bzw. die Nutzung des Drucks beim heißisostatischen Pressen erweist sich dabei zudem als vorteilhaft, weil dadurch Lufteinschlüsse bzw. Hohlräume zwischen der Metallschicht einerseits und dem Keramikelement andererseits reduziert werden können, wodurch die Ausbildung von Lunkern in ihrer Häufigkeit im gebildeten bzw. gefertigten Metall-Keramik-Substrat reduziert oder gar vermieden werden kann. Dies wirkt sich vorteilhaft auf die Qualität der Bindung zwischen der Metallschicht des Metallbehälters und dem Keramikelement aus. Darüber hinaus ist es in vorteilhafter Weise möglich, das "second etching" zu vereinfachen und Lotreste sowie eine Silbermigration zu vermeiden.

Dabei umfasst die Aktivmetallschicht umfassende Kontaktschicht Aktivmetall von mehr als 15 Gew. %.

Das heißisostatische Pressen ist beispielsweise aus der EP 3 080 055 B1 bekannt, auf deren Inhalt bezüglich des heißisostatischen Pressens hiermit explizit Bezug genommen wird.

Weiterhin ist die Materialschwächung bevorzugt als kuppelförmige Aussparung ausgebildet. Dabei ist es vorstellbar, dass eine Öffnung dieser kuppelförmigen Aussparungen in der Rückseitenmetallisierung dem Keramikelement zugewandt ist und/oder von diesem abgewandt ist. Als Materialschwächung wäre es auch vorstellbar, dass ein Materialabschnitt in der Rückseitenmetallisierung vorgesehen ist, dessen Material sich von dem unterscheidet, aus dem die Rückseitenmetallisierung gefertigt ist. Beispielsweise könnte man in die jeweiligen Aussparungen, die in die Rückseitenmetallisierung eingelassen sind, entsprechende Füllmaterialien einfüllen, deren Ausdehnungskoeffizienten nichts wesentlich dazu beitragen, dass thermomechanische Spannungen ausgeformt oder unterstützt/verstärkt werden. Solche Füllmaterialien erhöhen die Stabilität, ohne die gewünschte thermomechanische Symmetrie zwischen Bauteilseite und Rückseite zu gefährden.

Die Aussparungen können weiterhin einen kreisförmigen, einen rautenförmigen, einen quadratischen oder einen rechteckigen bzw. polygonalen Querschnitt in einer parallel zur Haupterstreckungsebene verlaufenden Richtung aufweisen.

Insbesondere ist zu beachten, dass die deckungsgleiche Anordnung die Anordnung der Materialschwächung betrifft. Demgegenüber ist es beispielsweise nicht notwendig, dass eine rückseitige Materialschwächung für jeden Teilbereich des bauteilseitigen Isolationsabschnitts vorgesehen ist. Mit anderen Worten: Eine von den Isolationsabschnitten eingenommene erste Gesamtfläche in der Bauteilmetallisierung ist erfindungsgemäß größer als eine von den Materialschwächungen eingenommene zweite Gesamtfläche in der Rückseitenmetallisierung. Dabei ist es erfindungsgemäß t vorgesehen, dass ein Verhältnis der zweiten Fläche zur ersten Fläche einen Wert annimmt, der zwischen 0,6 und 0,9, bevorzugt zwischen 0,7 und 0,9 und besonders bevorzugt zwischen 0,75 und 0,9 liegt. Hierbei bleiben bevorzugt weitere Materialschwächung unberücksichtigt, die zusätzlich zu den Materialschwächungen realisiert sind, die deckungsgleich zu den Isolationsabschnitten in die Rückseitenmetallisierung eingelassen sind.

Erfindungsgemäß ist es vorstellbar, dass sich der Isolationsabschnitt in der Bauteilmetallisierung entlang eines ersten Verlaufs erstreckt, insbesondere ununterbrochen erstreckt, während auf der gegenüberliegenden Seite in deckungsgleicher Anordnung in der Rückseitenmetallisierung eine Mehrzahl an voneinander separierten Materialschwächungen ausgebildet ist. Weiterhin ist es vorgesehen, dass die Materialschwächung an einer Außenseite der Rückseitenmetallisierung, die dem Keramikelement abgewandt ist, eine erste Ausdehnung aufweist, die kleiner ist als 1,0 mm, bevorzugt kleiner als 0,8 mm und besonders bevorzugt kleiner als 0,7 mm. Weiterhin ist es erfindungsgemäß vorgesehen, wenn zwei benachbarte Materialschwächungen in einem ersten Abstand zueinander angeordnet sind, der kleiner ist als 600 µm, bevorzugt kleiner als 400 µm und besonders bevorzugt kleiner als 250 µm. Weiterhin ist es vorstellbar, dass sich der erste Abstand und/oder die erste Ausdehnung für mehrere Materialschwächungen unterscheiden. Alternativ ist es vorstellbar, dass beispielsweise die erste Ausdehnung oder der erste Abstand zweier benachbarter Materialschwächungen in der Rückseitenmetallisierung gleich groß ist.

Vorzugsweise ist es vorgesehen, dass der Isolationsabschnitt in der Bauteilmetallisierung in einer parallel zur Haupterstreckungsebene verlaufenden Ebene einem ersten Verlauf und eine Materialschwächung oder mehrere Materialschwächungen in der Rückseitenmetallisierung in einer parallel zur Haupterstreckungsebene verlaufenden Ebene einem zweiten Verlauf folgen, wobei in Stapelrichtung der zweite Verlauf deckungsgleich zum ersten Verlauf ist, insbesondere ist der zweite Verlauf zu mehr als 50% seiner Gesamterstreckung, bevorzugt mehr als 70% und besonders bevorzugt mehr als 90 % oder vollständig deckungsgleich zu dem ersten Verlauf. Somit sind die Materialschwächungen und der Isolationsabschnitt nicht nur in einem Querschnitt, der senkrecht zur Haupterstreckungsebene verläuft, deckungsgleich zueinander angeordnet, sondern auch in Hinblick auf ihren ersten und der zweiten Verlauf, entlang derer sich die Isolationsabschnitte und Materialschwächungen in einer parallel zur Haupterstreckungsebene verlaufenden Ebene erstrecken. Dabei ist es vorstellbar, dass vereinzelte Abschnitte bzw. Teilabschnitte in der Rückseitenmetallisierung weggelassen werden in Bezug auf ihre deckungsgleiche Anordnung zu dem Isolationsabschnitt bzw. den Isolationsabschnitten. Mit anderen Worten: Sofern es sich um eine Materialschwächung an der Rückseitenmetallisierung handelt, ist diese vorzugsweise stets deckungsgleich angeordnet zu einem Isolationsabschnitt, während für den Isolationsabschnitt eine Materialschwächung in der Rückseitenmetallisierung nicht zwingend deckungsgleich zum Isolationsabschnitt erforderlich ist. Dadurch kann im Bedarfsfall verhindert werden, dass durch eng aneinander liegende Isolationsabschnitte die Rückseitenmetallisierung in diesem Metallbereich eine zu große Schwächung erfährt.

Der erste Verlauf und/oder der zweite Verlauf kann dabei gerade oder gebogene Teilabschnitte aufweisen, die zueinander gewinkelt oder versetzt zueinander angeordnet sind. Weiterhin ist es bevorzugt vorgesehen, dass der zweite Verlauf der Materialschwächung bzw. der Materialschwächungen durch eine Aneinanderreihung von Materialschwächungen, beispielsweise in Form einer Lochreihe bzw. eine Aneinanderreihung von kuppelförmigen Aussparungen, ausgebildet ist und/oder dass entlang des zweiten Verlaufs die Rückseitenmetallisierung zwischen zwei Materialschwächungen einen Stabilisierungsbereich aufweist. Insbesondere wird eine Lochreihe durch eine Aneinanderreihung von benachbarten kuppelförmigen Aussparungen gebildet. Dabei ist es vorstellbar, dass zwischen zwei benachbarten kuppelförmigen Aussparungen ein Teilabschnitt ausgebildet ist, in dem die Rückseitenmetallisierung die zweite Dicke aufweist bzw. eine Restmetallisierung vorgesehen ist, die größer ist als die Restmetallisierung zwischen Aussparung und Keramikelement. Dadurch wird die Stabilität des Metall-Keramik-Substrats trotz Erhöhung der Symmetrie beibehalten. Vorzugsweise ist es vorgesehen, dass ein erster Abstand zwischen zwei benachbarten Materialschwächungen kleiner ist als 600 µm, kleiner als 400 µm und besonders bevorzugt kleiner als 250 µm. Insbesondere ist es vorgesehen, dass die Aussparungen durch ein chemisches, beispielsweise Ätzverfahren, durch ein mechanisches Verfahren, beispielsweise ein Fräsen, oder durch ein optisches Verfahren, beispielsweise mittels Laserlichts, insbesondere Laserpulsen, hergestellt wird. Gerade die Verwendung von Laserlicht gestattet die möglichst schmale und genau platzierte Ausbildungen der Materialschwächungen, insbesondere der Aussparungen. Der Stabilisierungsbereich zeichnet sich dabei bevorzugt dadurch aus, dass die Materialschwächung weniger ausgeprägt ist. Beispielswiese ist eine Tiefe einer Aussparung im Stabilisierungsbereich geringer oder es liegt bereichsweise sogar gar keine Aussparung im Stabilisierungsbereich vor.

Vorzugsweise ist es vorgesehen, dass zusätzlich zu der Materialschwächung, die deckungsgleich angeordnet ist zu den Isolationsabschnitten, eine weitere Materialschwächung vorgesehen ist, die in der Rückseitenmetallisierung in einem Randbereich der Rückseitenmetallisierung eingelassen ist. Im Gegensatz zu der Materialschwächung ist es für die weitere Materialschwächung vorgesehen, dass in Stapelrichtung gesehen auf der gegenüberliegenden Seite keine deckungsgleich angeordneten Isolationsabschnitte vorgesehen oder ausgebildet sind.

Beispielsweise ist es bevorzugt vorgesehen, dass die weitere Materialschwächung in einem solchen Randbereich der Rückseitenmetallisierung angeordnet ist, der in einer parallel zur Haupterstreckungsebene verlaufenden Richtung gegenüber der Bauteilmetallisierung vorsteht. In diesem Fall ist die Bauteilmetallisierung kleiner als die Rückseitenmetallisierung, insbesondere in Hinblick auf ihre Ausdehnung entlang der Haupterstreckungsebene. Dabei können die weiteren Materialschwächungen eine Lochreihe bilden oder als flach verlaufende Seitenfläche ausgebildet sein, d. h. insbesondere mit einem vergleichsweise geringen Neigungswinkel ausgebildet sein, der beispielsweise mindestens um einen Faktor 2, bevorzugt mindestens um einen Faktor 3 und besonders bevorzugt mindestens um einen Faktor 5 kleiner ist als ein entsprechender Neigungswinkel auf der Bauteilseite. Durch die unterschiedlichen Ausdehnungen von Bauteilmetallisierung und Rückseitenmetallisierung wird auf der Bauteilseite für einen ausreichenden Abstand zur äußeren Kante des Keramikelements gesorgt, um einen elektrischen Überschlag zu vermeiden, während der gegenüber der Bauteilmetallisierung vorstehende Abschnitt der Rückseitenmetallisierung die Stabilität des Metall-Keramik-Substrats im Randbereich erhöht.

Es hat sich herausgestellt, dass durch diese Maßnahme der weiteren Materialschwächungen eine zusätzliche Verbesserung am Metall-Keramik-Substrat erzielt werden kann, die einer Anfälligkeit des Metall-Keramik-Substrats zum Durchbiegen entgegenwirken kann und insbesondere auch die Temperaturwechselbeständigkeit weiter erhöht. Dabei kann die randseitige weitere Materialschwächung auch als geschwungener Flankenverlauf mit mindestens einem Zwischenmaximum ausgebildet sein. Ferner ist es bevorzugt vorgesehen, dass eine erste Ausdehnung der weiteren Materialschwächung kleiner ist als die erste Ausdehnung der Materialschwächung. Sofern die Materialschwächung und die weitere Materialschwächung jeweils untereinander unterschiedliche Ausdehnungen aufweisen, ist es bevorzugt vorgesehen, dass hierbei der jeweilige Mittelwert berücksichtigt wird. Ferner ist es vorgesehen, dass als Randbereich der Teilabschnitt der Metallisierung bzw. Rückseitenmetallisierung zu verstehen ist, der sich ausgehend vom Außenumfang der Rückseitenmetallisierung erstreckt und dabei weniger als 10%, bevorzugt weniger als 5% und besonders bevorzugt weniger als 2% der Gesamtfläche der Rückseitenmetallisierung einnimmt. Weiterhin ist es vorgesehen, dass die weitere Materialschwächung den Bereich mit den Materialschwächungen umgibt, insbesondere vollständig umrahmt.

Weiterhin ist es bevorzugt vorgesehen, dass eine als Aussparung ausgebildete Materialschwächung bis zum Keramikelement verläuft bzw. sich bis zum Keramikelement erstreckt. Dadurch wird ein hohes Maß an Symmetrie von Bauteilseite und Rückseite realisiert. Alternativ ist es vorstellbar, dass eine Restmetallisierung ausgebildet ist im Bereich der Materialschwächung, sodass diese Restmetallisierung dazu beitragen kann, dass die Stabilität des gesamten Metall-Keramik-Substrats erhöht wird. Dies ist besonders vorteilhaft bei der Verwendung von sehr dünnen Isolationsschichten bzw. Keramikelementen, die andernfalls eine erhöhte Tendenz zum Brechen aufweisen würden. Beispielsweise ist es vorgesehen, dass in Stapelrichtung bemessen die Restmetallisierung eine vierte Dicke aufweist, wobei ein Verhältnis der vierten Dicke zur zweiten Dicke kleiner als 0,5, bevorzugt kleiner als 0,4 und besonders bevorzugt kleiner als 0,2 ist.

Vorstellbar ist auch, dass zwischen der als Aussparung ausgebildeten weiteren Materialschwächung und dem Keramikelement eine Restmetallisierung ausgebildet ist, insbesondere wenn die als Aussparung ausgebildete Materialschwächung bis zum Keramikelement reicht. Dadurch unterscheidet sich beispielsweise die Materialschwächung von der weiteren Materialschwächung im Randbereich.

Vorzugsweise ist es vorgesehen, dass eine erste Breite des Isolationsabschnitts festgelegt wird durch einen Abstand zwischen dem ersten Metallabschnitt und dem zweiten Metallabschnitt, gemessen entlang einer ersten Richtung, die senkrecht zum ersten Verlauf verläuft, wobei ein Verhältnis einer zweiten Breite der Materialschwächung, gemessen entlang der ersten Richtung, zur ersten Breite einen Wert zwischen 0,1 und 2, bevorzugt zwischen 0,5 und 1,5 und besonders bevorzugt zwischen 0,75 und 0,9 annimmt. Insbesondere hat es sich gezeigt, dass bereits ein ausreichender Grad an Symmetrie bezüglich der thermodynamischen Ausdehnung an Bauteilseite und Rückseite eingestellt werden kann, wenn an der Rückseitenmetallisierung die Materialschwächung sich nicht über die volle zweite Breite des Isolationsabschnitts erstreckt. Dadurch kann die Stabilität des Metall-Keramik-Substrats weiter aufrechterhalten werden, ohne befürchten zu müssen, dass aufgrund des geringen Materialanteils an der Rückseite eine mögliche Bruchstelle für das Metall-Keramik-Substrat entsteht.

Vorzugsweise ist es vorgesehen, dass ein Verhältnis von Abschnitten, bei denen der erste Verlauf und der zweite Verlauf in Stapelrichtung gesehen nicht deckungsgleich verlaufen, zu Abschnitten, bei denen der erste Verlauf und der zweite Verlauf in Stapelrichtung gesehen deckungsgleich zueinander verlaufen, einen Wert annimmt der kleiner ist als 1, bevorzugt kleiner als 0,5 und besonders bevorzugt kleiner als 0,2. Es hat sich dabei herausgestellt, dass mit zunehmendem Anteil von deckungsgleich angeordneten Materialschwächungen die Gesamtsymmetrie an Vorder- und Rückseite des Metall-Keramik-Bauteils erhöht werden kann, wodurch insgesamt die Neigung zum Durchbiegen für die entsprechend ausgestalteten Metall-Keramik-Substrate weiterverbessert werden bzw. reduziert werden kann.

Vorzugsweise ist es vorgesehen, dass an die Rückseitenmetallisierung ein Kühlkörper angebunden ist. Insbesondere ist es dabei vorgesehen, dass die Materialschwächung beispielsweise in Form der Aussparung in die Rückseitenmetallisierung eingelassen ist. Somit handelt es sich bei der in die Rückseitenmetallisierung eingelassene Materialschwächung nicht um eine Aussparung, die in den Kühlkörper eingelassen ist, der an die Rückseitenmetallisierung angebunden ist und insbesondere dazu vorgesehen ist, an ein Kühlfluid die entstandene Wärme im Betrieb des bestimmten Metall-Keramik-Substrats abzuführen.

Insbesondere ist es vorgesehen, dass pro Längeneinheit entlang des ersten Verlaufs und/oder des zweiten Verlaufs der Isolationsabschnitt ein erstes Volumen annimmt und die Materialschwächung in der Rückseitenmetallisierung ein zweites Volumen annimmt, wobei das erste Volumen und das zweite Volumen in Hinblick auf ihre absolute Größen im Wesentlichen gleich groß sind und in Hinblick auf ihre geometrische Formen unterschiedlich sind. Dadurch kann auf der einen Seite die Symmetrie zwischen den Aussparungen in der Bauteilmetallisierung und den Aussparungen in der Rückseitenmetallisierung möglichst groß gehalten werden und gleichzeitig können Maßnahmen getroffen werden, die die Stabilität in den Bereichen stärken, in denen der Isolationsabschnitt bzw. die Materialschwäche eingelassen ist. Dabei versteht der Fachmann vorzugsweise unter "im Wesentlich gleich" großen Volumina solche, die nicht zu mehr als 10% bevorzugt nicht mehr als 5 % und besonders nicht mehr als 2,5 % ihres Mittelwertes voneinander abweichen. Dabei können sich das erste Volumen und das zweite Volumen beispielsweise in Hinblick auf ihre Tiefe, ihre Breite und/oder ihre Länge unterscheiden. Entsprechend können beispielsweise für unterschiedlich tiefe Aussparungen an der Bauteilseite und der Rückseite entsprechend unterschiedliche Breiten bzw. Durchmesser verwendet werden, um dafür zu sorgen, dass die Volumina der Aussparungen in der Bauteilmetallisierung und der Rückseitenmetallisierung im Wesentlichen übereinstimmen.

Gemäß einem anderen Gegenstand der vorliegenden Erfindung ist ein Metall-Keramik-Substrat, das als Leiterplatte zum Befestigen von elektrischen Bauteilen vorgesehen ist, vorgesehen, umfassend:
- eine Bauteilmetallisierung und eine Rückseitenmetallisierung und
- ein Keramikelement, das entlang einer Stapelrichtung zwischen der Bauteilmetallisierung und der Rückseitenmetallisierung angeordnet ist,

wobei die Bauteilmetallisierung einen ersten Metallabschnitt und einen zweiten Metallabschnitt aufweist, wobei der erste Metallabschnitt und der zweite Metallabschnitt durch einen Isolationsabschnitt voneinander getrennt sind und/oder auf dem ersten Metallabschnitt ein Anschlussbereich für ein elektrisches Bauteil vorgesehen ist, und
wobei die Rückseitenmetallisierung eine Materialschwächung, insbesondere eine Materialaussparung, aufweist, die in Stapelrichtung gesehen zumindest bereichsweise deckungsgleich zum Anschlussbereich angeordnet ist. Alle für das Metall-Keramik-Substrat mit den zu den Isolationsabschnitten deckungsgleich angeordneten Materialschwächungen beschriebenen Vorteile und Eigenschaften lassen sich analog übertragen auf die Metall-Keramik-Substrate mit den zu den Anschlussbereichen deckungsgleichen Materialschwächungen beschriebenen Vorteile und Eigenschaften bzw. Spezifikationen und andersrum. Erfindungsgemäß ist ein Metall-Keramik-Substrat vorgesehen, dass sowohl Materialaussparungen aufweist, die deckungsgleich zu den Isolationsabschnitten sind, als auch (weitere) Materialaussparungen, die deckungsgleich zu dem Anschlussbereich sind.

Bevorzugt zeichnet sich der Anschlussbereich durch eine entsprechende flächige Ausdehnung aus, die sich augenscheinlich unterscheidet von Leiterbahnen, weil sie in einer Haupterstreckungsebene breiter sind als Leiterbahnen. Dabei ist es vorstellbar, dass die Materialschwächung sich über den gesamten Bereich erstreckt der deckungsgleich unterhalb des Anschlussbereichs angeordnet ist. Es ist auch vorstellbar, dass der deckungsgleich zum Anschlussbereich ausgebildete Teilabschnitt der Rückseitenmetallisierung nur bereichsweise Materialschwächungen aufweist, beispielsweise deckungsgleich zu einem Randabschnitt des Anschlussbereichs. Vorzugsweise sind die Materialschwächungen, die deckungsgleich unterhalb des Anschlussbereichs angeordnet sind, in einem zweidimensionalen Muster angeordnet.

Ein weiterer Gegenstand der vorliegenden Erfindung ist ein Verfahren zur Herstellung eines Metall-Keramik-Substrats, insbesondere zur Herstellung eines erfindungsgemäßen Metall-Keramik-Substrats, umfassend:
- Bereitstellen einer Bauteilmetallisierung und einer Rückseitenmetallisierung, sowie eines Keramikelements,
- Anbinden der Bauteilmetallisierung und der Rückseitenmetallisierung an das Keramikelement, wobei das Keramikelement entlang einer Stapelrichtung zwischen der Bauteilmetallisierung und der Rückseitenmetallisierung angeordnet wird,
- Strukturieren der Bauteilmetallisierung durch Realisieren von Isolationsabschnitten und
- Realisieren einer Materialschwächung in die Rückseitenmetallisierung, wobei die Materialschwächung in Stapelrichtung gesehen deckungsgleich zum Isolationsabschnitt angeordnet wird.

Alle für das Metall-Keramik-Substrat beschriebenen Vorteile und Eigenschaften bzw. Spezifikationen lassen sich analog übertragen auf das Verfahren und andersrum.

Weitere Vorteile und Merkmale ergeben sich aus der nachfolgenden Beschreibung bevorzugter Ausführungsformen des erfindungsgemäßen Gegenstands mit Bezug auf die beigefügten Figuren. Einzelne Merkmale der einzelnen Ausführungsform können dabei im Rahmen der Erfindung miteinander kombiniert werden.

Es zeigt:
- **Fig. 1:**: ein Metall-Keramik-Substrat gemäß dem Stand der Technik,
- **Fig. 2**: ein Metall-Keramik-Substrat gemäß einer ersten beispielhaften Ausführungsform der vorliegende Erfindung in einer Schnittansicht
- **Fig. 3**: ein Metall-Keramik-Substrat gemäß einer zweiten beispielhaften Ausführungsform der vorliegende Erfindung in einer Schnittansicht
- **Fig. 4**: Metall-Keramik-Substratsgemäß einer dritten beispielhaften Ausführungsform der vorliegende Erfindung,
- **Fig. 5**: zwei verschiedene Materialschwächungen für die Rückseitenmetallisierung
- **Fig. 6**: eine Bauteilmetallisierung (unten) und eine Rückseitenmetallisierung (oben) und eine Seitenansicht (Mitte) eines Metall-Keramik-Substrats gemäß einer vierten Ausführungsform der vorliegenden Erfindung und
- **Fig. 7**: einen Vergleich zwischen einer dem Isolationsabschnitt bildenden Aussparung und einer eine Materialschwächung bildend enden Aussparungen für ein Metall-Keramik-Substrat gemäß einer fünften beispielhaften Ausführungsform der vorliegende Erfindung.

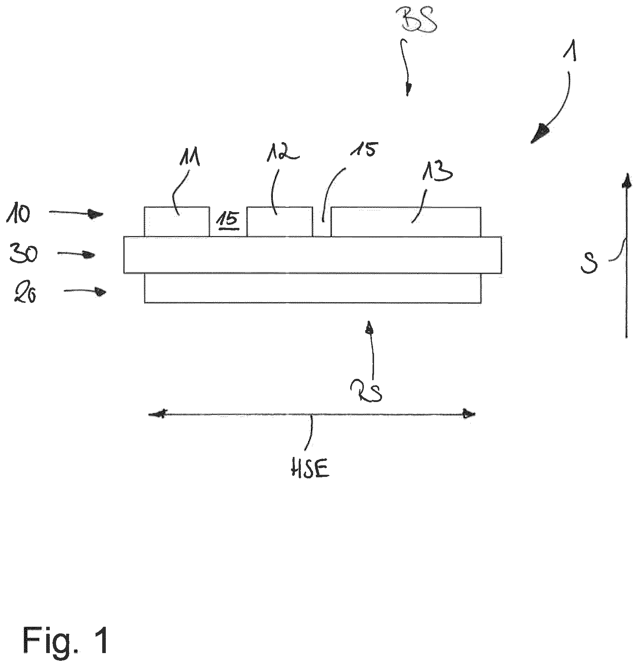

In **Figur 1** ist schematisch ein Metall-Keramik-Substrat 1 gemäß dem Stand der Technik dargestellt. Bei solch einem Metall-Keramik-Substrat 1 handelt es sich vorzugsweise um einen Träger für elektrische Bauteile. Dabei ist es insbesondere vorgesehen, dass das Metall-Keramik-Substrat 1 ein Keramikelement 30 und eine Bauteilmetallisierung 10 aufweist, wobei sich das Keramikelement 30 und die Bauteilmetallisierung 10 entlang einer Haupterstreckungsebene HSE erstrecken. Dabei ist die Bauteilmetallisierung 10 an dem Keramikelement 30 angebunden, wobei die Bauteilmetallisierung 10 und das Keramikelement 30 in einer senkrecht zur Haupterstreckungsebene HSE verlaufenden Stapelrichtung S übereinander angeordnet sind. Dabei ist es insbesondere vorgesehen, dass die Bauteilmetallisierung 10 eine Mehrzahl an Metallabschnitten, beispielsweise einen ersten Metallabschnitt 11, einen zweiten Metallabschnitt 12 und einen zweiten dritten Metallabschnitt 13, aufweist, die beispielsweise elektrisch isoliert voneinander und nebeneinander entlang einer parallel zur Haupterstreckungsebene HSE verlaufenden Richtung angeordnet sind.

Insbesondere ist es im Stand der Technik üblich, zunächst eine Anbindung der Bauteilmetallisierung 10 an das Keramikelement 30 vorzunehmen, insbesondere mittels eines Direktmetallanbindungsverfahren und/oder eines Aktivlötverfahrens bzw. AMB-Verfahrens und/oder ein ADB-Verfahren und/oder ein heißisostatisches Pressen. Solche Anbindungsverfahren sind Hochtemperaturverfahren, bei denen die Anordnung aus Keramikelement 30 und der Bauteilmetallisierung 10 einer erhöhten Temperatur ausgesetzt werden, insbesondere Temperaturen oberhalb von 500 °C. Nach dem Anbindungsprozess erfolgt anschließend, beispielsweise mittels eines Ätzverfahrens, die Strukturierung, um voneinander elektrisch isolierte Metallabschnitte, insbesondere einen ersten Metallabschnitt 11 und einen zweiten Metallabschnitt 12 zu realisieren, die als Leiterbahn und/oder Anschlussflächen, sogenannte Pads, für elektrische Schaltkreise genutzt werden können.

Auf der der Bauteilmetallisierung 10 gegenüberliegenden Seite des Keramikelements 30 ist vorzugsweise eine Rückseitenmetallisierung 20 angebunden, die insbesondere zeitgleich, d. h. in einem gemeinsamen Arbeitsschritt, mit der Bauteilmetallisierung 10 an das Keramikelement 30 angebunden wird. Alternativ werden die die Bauteilmetallisierung 10 und die Rückseitenmetallisierung nacheinander angebunden. Eine solche Rückseitenmetallisierung 20 dient insbesondere der Kompensation von thermomechanischen Spannungen in dem Metall-Keramik-Substrat 1, die aufgrund der unterschiedlichen thermomechanischen Ausdehnungskoeffizienten der Bauteilmetallisierung 10 und dem Keramikelement 30 veranlasst werden.

Dabei ist es vorgesehen, dass die Bauteilmetallisierung 10 mindestens einen ersten Metallabschnitt 11, einen zweiten Metallabschnitt 12 und/oder einen dritten Metallabschnitt 13 aufweist. Der erste Metallabschnitt 11, der zweite Metallabschnitt 12 und/oder der dritte Metallabschnitt 23 sind nach dem Strukturieren durch Isolationsabschnitte 15 voneinander getrennt, um entsprechende Leiterbahnen und/oder Anschlussflächen zu bilden, die untereinander elektrisch isoliert sind. Hierzu wird eine Strukturierung in die Bauteilmetallisierung 10 eingelassen, beispielsweise durch ein chemisches Verfahren und/oder ein mechanisches Verfahren und/oder ein optisches Verfahren, wobei eine für die Strukturierung notwendige Aussparung in der Bauteilmetallisierung 10 mindestens bis zum Keramikelement 30 reicht, um für die nötige elektrische Isolation zu sorgen. Solche Isolationsabschnitte 15 sind insbesondere grabenförmig in der Bauteilmetallisierung 10 ausgebildet und werden umgangssprachlich auch Isolationsgräben genannt. Die entsprechenden ersten Verläufe VE1 der grabenförmigen Isolationsabschnitte 15 folgen abhängig vom Anwendungsfall des als Leiterplatte vorgesehenen Metall-Keramik-Substrats 1 einem bestimmten Muster. Insbesondere ist es vorgesehen, dass der erste Verlauf der Isolationsabschnitte 15 für eine Serie von hergestellten Metall-Keramik-Substraten 1 für den entsprechenden Anwendungsfall individuell eingestellt ist.

Um für die gewünschte Symmetrie zwischen einer Bauteilseite BS und einer Rückseite RS des Metall-Keramik-Substrats 1 zu sorgen, wodurch entsprechende thermomechanische Spannungen, die im Metall-Keramik-Substrat 1 auftreten, einander kompensieren können, ist es vorgesehen, dass die Rückseitenmetallisierung 20 und die Bauteilmetallisierung 10 im Wesentlichen eine vergleichbare Dicke aufweisen. Die Dicken werden dabei entlang einer der Stapelrichtung S folgenden Richtung gemessen.

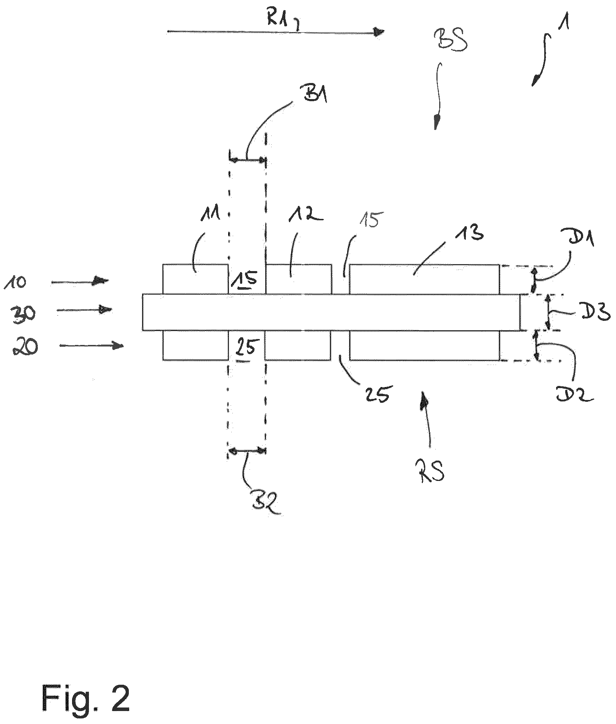

In **Figur 2** ist ein Metall-Keramik-Substrat 1 gemäß einer ersten beispielhaften Ausführungsform der vorliegenden Erfindung dargestellt. Um eine Anfälligkeit der Metall-Keramik-Substrate 1 zur Durchbiegung zu reduzieren, ist es hierbei vorgesehen, dass neben den Isolationsabschnitten 15 in der Bauteilmetallisierung 10 Materialschwächungen 25 in die Rückseitenmetallisierung 20 eingelassen sind. In der in Figur 2 dargestellten Ausführungsform handelt es sich bei den Materialschwächungen 25 um Aussparungen in der Rückseitenmetallisierung 20, die insbesondere bis zum Keramikelement 20 reichen und zu einer vollständigen Isolation von Teilabschnitten der Rückseitenmetallisierung 30 führen. Insbesondere ist es vorgesehen, dass die Materialschwächung 25 in Stapelrichtung S gesehen im Wesentlichen deckungsgleich zum Isolationsabschnitt 15 angeordnet ist. Dadurch wird in vorteilhafter Weise die Symmetrie zwischen Bauteilseite BS und Rückseite RD weiter erhöht und somit die Anfälligkeit zum Durchbiegen des Metall-Keramik-Substrats 1 weiter reduziert. Dabei ist es weiterhin vorgesehen, dass die Bauteilmetallisierung 10 eine erste Dicke D1 und die Rückseitenmetallisierung 20 eine zweite Dicke D2 aufweist, wobei die erste Dicke D1 und zweite Dicke D2 im Wesentlichen gleich groß ist. Dabei versteht man unter "im Wesentlichen", dass Abweichungen zwischen der ersten Dicke D1 und zweiten Dicke D2 kleiner sind als 10 %, bevorzugt kleiner als 5 % uns besonders bevorzugt kleiner als 2,5 % des Mittelwertes der ersten Dicke D1 und/oder zweiten Dicke D2.

Weiterhin ist es vorgesehen, dass das Keramikelement 30 eine dritte Dicke D3 aufweist. Vorzugsweise ist es vorgesehen, dass die dritte Dicke D3 einen Wert annimmt, der kleiner ist als 700 µm, bevorzugt kleiner als 400 µm und besonders bevorzugt kleiner als 330 µm. Damit handelt es sich um vergleichsweise dünne Isolationsschichten bzw. Keramikelemente 30, die in entsprechender Weise anfälliger sind für ein Durchbiegen. Durch das Erhöhen der Symmetrie, verursacht durch das zusätzliche Einlassen der deckungsgleich angeordneten Materialschwächung 25, ist es somit in vorteilhafter Weise auch möglich, einem Durchbiegen bei solchen Metall-Keramik-Substraten 1 entgegenzuwirken, bei denen eine vergleichsweise dünne Isolationsschicht, d. h. ein vergleichsweise dünnes Keramikelement 30 verwendet wird.

Weiterhin ist es vorgesehen, dass der Isolationsabschnitt eine erste Breite B1 aufweist und die Materialschwächung 25 eine zweite Breite B2 aufweist. Vorzugsweise ist es dabei vorgesehen, dass die zweite Breite B2 kleiner ist als die erste Breite B1. Vorstellbar ist insbesondere, dass ein Verhältnis der zweiten Breite B2 zur ersten Breite B1 einen Wert zwischen 0,1 und 2,0, bevorzugt zwischen 0,5 und 1,5 und besonders bevorzugt zwischen 0,75 und 0,5 annimmt. In dem in Figur 2 dargestellten Ausführungsbeispiel verlaufen die Seitenflächen der Rückseitenmetallisierung 20 im Bereich der als Aussparung ausgebildeten Materialschwächung 25 im Wesentlichen senkrecht zur Haupterstreckungsebene HSE. Vorzugsweise ist es hier aber vorgesehen, dass die ausgebildeten Seitenflächen gebogen bzw. schräg verlaufen, insbesondere wenn die in die Rückseitenmetallisierung 20 eingelassene Materialschwächung 25 durch ein Ätzverfahren realisiert ist.

Die erste Breite des Isolationsabschnitts 15 wird insbesondere bestimmt durch den minimalen Abstand zweier gegenüberliegender Metallabschnitte 11, 12, 13 an der Stelle des Isolationsabschnitts 15, der vermessen werden soll. Dabei liegt eine erste Richtung R1, entlang der die erste Breite B1 bestimmt wird, innerhalb der Haupterstreckungsebene HSE und insbesondere senkrecht zu der Richtung entlang der sich der Isolationsabschnitt 15 gemäß eines ersten Verlaufs VE1 in der Haupterstreckungsebene HSE erstreckt. Dieser erste Verlauf VE1 wird vorgegeben durch das entsprechende Muster, das für das jeweilige Metall-Keramik-Substrat 1 vorgesehen ist. Die Größe der zweiten Breite B2 wird vorzugsweise an derselben Position auf der Rückseite RS entlang derselben ersten Richtung R1 bestimmt.

Weiterhin ist unter "deckungsgleich" zu verstehen, dass entlang einer parallel zur Stapelrichtung S erfolgenden gedachte Projektion der Ausdehnung der Materialschwächung 25 auf die Ausdehnung des Isolationsabschnitt 15 gedanklich ein räumlicher Überlapp festzustellen wäre, der insbesondere größer ist als 50%, bevorzugt größer als 75% und besonders bevorzugt größer als 95%. Dabei können die Mitten der Ausdehnungen der Materialschwächung 25 und die Mitte des Isolationsabschnitts 15 in Stapelrichtung übereinanderliegen oder seitlich zueinander versetzt sein, insbesondere in der Haupterstreckungsebene HSE entlang einer senkrecht zum ersten Verlauf VE1 bzw. senkrecht zum zweiten Verlauf VE2 verlaufenden Richtung.

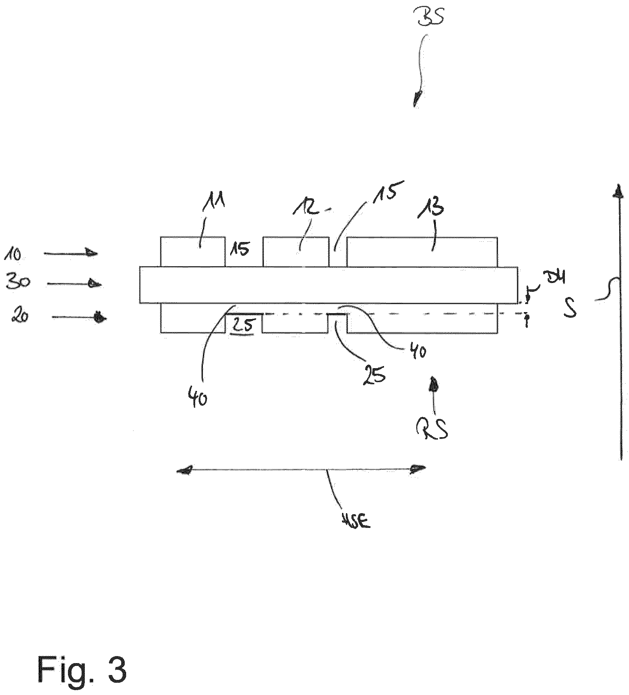

In **Figur 3** ist eine Schnittansicht durch ein Metall-Keramik-Substrat 1 gemäß einer zweiten beispielhaften Ausführungsform der vorliegenden Erfindung dargestellt. Dabei unterscheidet sich das Ausführungsbeispiel der Figur 3 im Wesentlichen von dem Ausführungsbeispiel der Figur 2 nur dahingehend, dass in dem Ausführungsbeispiel der Figur 3 die als Aussparung ausgebildete Materialschwächung 25 nicht bis zum Keramikelement 30 reicht. Insbesondere ist es hier vorgesehen, dass eine Restmetallisierung 40 im Bereich der Materialschwächung 25 vorgesehen ist. Diese Restmetallisierung 40 weist eine vierte Dicke D4 auf, die kleiner ist als die zweite Dicke D2. Vorzugsweise ist ein Verhältnis der vierten Dicke D4 zur zweiten Dicke D2 kleiner als 0,5, bevorzugt kleiner als 0,25 und besonders bevorzugt kleiner als 0,1. Dieses Ausführungsbeispiel hat den Vorteil, dass mittels der Restmetallisierung 40 zu der Stabilität des Keramikelements 30 beigetragen werden kann, wobei gleichzeitig dem Symmetriegedanken von Bauteilseite BS und Rückseite RS Rechnung getragen wird. Dabei ist es vorstellbar, dass die zweite Dicke D2 kleiner ist als die erste Dicke D1, um die Anwesenheit der Restmetallisierung 40 zu kompensieren. Weiterhin ist es vorstellbar, dass in einem weiteren Ausführungsbeispiel als Aussparung vorgesehene Materialschwächung 25 in einem Metall-Keramik-Substrat 1 zum Teil bis zum Keramikabschnitt 30 reichen und andere Abschnitte eine Restmetallisierung 40 aufweisen. Mit anderen Worten: das Metall-Keramik-Substrat 1 umfasst als Aussparungen ausgeformte Materialschwächungen 25, die teils bis zum Keramikelement 30 reichen und teils eine Restmetallisierung 40 aufweisen.

Weiterhin ist es vorstellbar, dass in einem anderen Ausführungsbeispiel die vierte Dicke D4 für verschiedene Materialschwächungen 25 unterschiedlich ist und variiert und insbesondere angepasst ist an das Ausmaß der zu erwartenden thermomechanischen Spannungen für das jeweilige Layout/Muster bzw. für die jeweils geplanten erste Verläufe VE1 der Isolationsabschnitte 15.

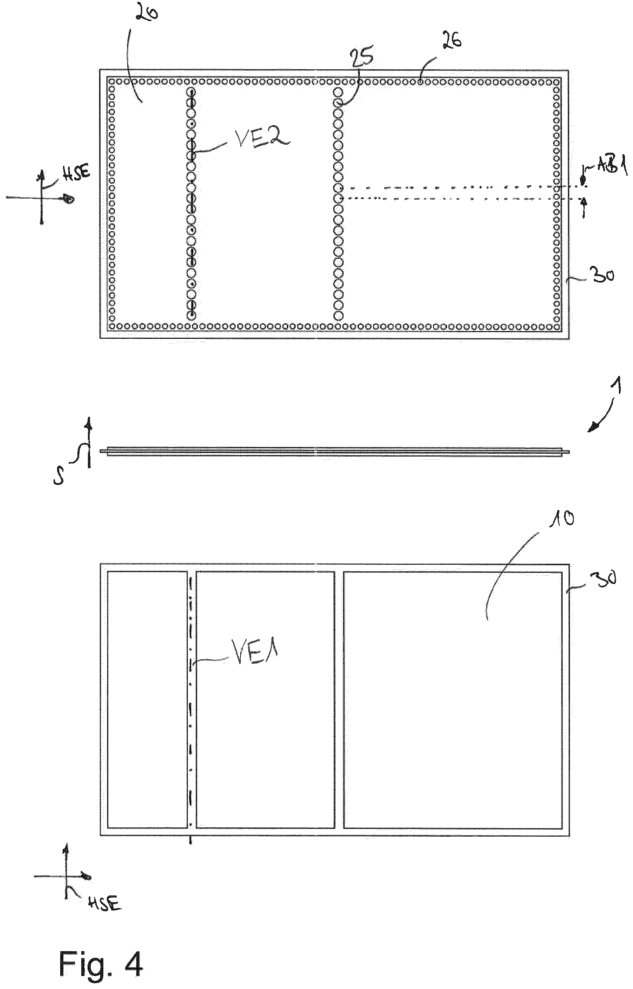

In **Figur 4** ist eine Seitenansicht (Mitte), eine Draufsicht auf die Rückseite RS ( oben) und ein Draufsicht auf die Bauteilseite BS(unten) eines Metall-Keramik-Substrats 1 gemäß einer dritten beispielhaften Ausführungsform der vorliegenden Erfindung dargestellt). Insbesondere ist es dabei vorgesehen, dass die Materialschwächung 25 in der Rückseitenmetallisierung 20 als Lochreihe bzw. als Aneinanderreihung von Materialschwächungen 25 ausgebildet ist. Eine solche Lochreihe erweist sich insbesondere deswegen als vorteilhaft, weil durch die zwischen den einzelnen Löchern beibehaltende Metallisierung die Stabilität des Metall-Keramik-Substrats 1 erhöht wird bei gleichzeitiger Erhöhung der Symmetrie der Materialverteilung auf Bauteilseite BS und Rückseite RS des Metall-Keramik-Substrats 1. Vorzugsweise handelt es sich bei der Lochreihe um eine Aneinanderreihung von kreis- und/oder kuppelförmigen Aussparungen. Die in der Schnittansicht dargestellten Ausführungsformen der Aussparung reicht einmal bis zum Keramikelement 30 (links) und einmal endet die Aussparung in der Rückseitenmetallisierung (rechts), d. h. es ist eine Restmetallisierung 40 zwischen der Aussparung und dem Keramikelement 30 vorgesehen.

Weiterhin ist es vorgesehen, dass die Lochreihe bzw. die Aneinanderreihung von Materialschwächung 25 einem zweiten Verlauf VE2 folgt, der insbesondere deckungsgleich ist zu einem ersten Verlauf VE1, der durch den Isolationsabschnitt 15 auf der Bauteilseite BS bzw. in der Bauteilmetallisierung 10 vorgegeben ist. Dabei können der erste Verlauf VE1 und zweite Verlauf VE2 in der Haupterstreckungsebene HSE jeweils zueinander gewinkelte Teilabschnitte aufweisen und/oder gebogene Teilabschnitte aufweisen, die beispielsweise geradlinige Teilabschnitte miteinander verbinden. Weiterhin ist es vorstellbar, dass der erste Verlauf VE1 und/oder zweite Verlauf VE2 Verzweigungen aufweist.

Weiterhin ist es besonders bevorzugt vorgesehen, dass ein erster Abstand AB1 zwischen zwei benachbarten Aussparungen bzw. Materialschwächungen 25 kleiner ist als 600 µm, bevorzugt kleiner als 400 µm und besonders bevorzugt kleiner als 250 µm. Insbesondere ist es vorgesehen, dass der erste Abstand AB1 zwischen zwei Materialschwächungen größer ist als die erste Ausdehnung E1.

Es ist auch vorstellbar, dass die als Lochreihe angeordneten Aussparungen einander berühren bzw. ineinander übergehen und nicht voneinander durch einen Metallabschnitt, der bis zur Außenseite der Rückseitenmetallisierung reicht, voneinander getrennt werden.

Weiterhin ist es bevorzugt vorgesehen, dass neben der Materialschwächung 25 eine weitere Materialschwächung 26 vorgesehen ist, die sich im Randbereich der Rückseitenmetallisierung 20 ausbildet. Insbesondere ist die weitere Materialschwächung 26 als Aneinanderreihung von weiteren Materialschwächungen 26, insbesondere als Lochreihe, ausgeformt, wobei sich die Aneinanderreihung rahmenartig entlang eines Randbereichs der Rückseitenmetallisierung 20 bzw. des Metall-Keramik-Elements 1 erstreckt. Insbesondere ist es vorgesehen, dass der Verlauf der weiteren Materialschwächung 26 außerhalb eines Bereichs liegt, in dem die Materialschwächungen 25 ausgebildet sind, die deckungsgleich zum ersten Verlauf VE1 bzw. der Anordnung der Isolationsabschnitte 15 auf der Bauteilseite BS angeordnet sind. Weiterhin ist es vorgesehen, dass die weitere Materialschwächung 26, insbesondere ausgebildet als weitere Aussparungen, an der Außenseite der Rückseitenmetallisierung 20, die dem Keramikelement 30 abgewandt ist, eine erste Ausdehnung E1 aufweist, die kleiner ist als die erste Ausdehnung E1 der Materialschwächung 25. Ferner nimmt ein Verhältnis der ersten Ausdehnung E1 der weiteren Materialschwächung 26 zur ersten Ausdehnung E1 der Materialschwächung 25 einen Wert an, der kleiner ist als 0,7, kleiner als 0,6 und besonders bevorzugt kleiner als 0,5. Vorzugsweise ist die erste Ausdehnung E1 der weiteren Materialschwächung 26 kleiner als 1,2 mm, bevorzugt kleiner als 0,9 mm und besonders bevorzugt kleiner als 0,7 mm. Weiterhin ist es bevorzugt vorgesehen, dass ein erster Abstand AB1 zwischen zwei benachbarten weiteren Materialschwächungen 26 kleiner ist als der Abstand zwischen zwei Materialschwächungen 25. Der Abstand der Materialschwächung 25 bzw. weiteren Materialschwächung 26 untereinander wird hier bestimmt von Mitte zu Mitte der jeweiligen Aussparung. Weiterhin ist es bevorzugt vorgesehen, dass als Randbereich derjenige Bereich verstanden wird, der sich vom Außenumfang in Richtung des Zentrums der Rückseitenmetallisierung 20 erstreckt, wobei sich die Erstreckung des Randbereichs beschränkt auf maximal 10% der Gesamtausdehnung der Rückseitenmetallisierung 20, insbesondere maximal 5% und besonders bevorzugt maximal 2%.

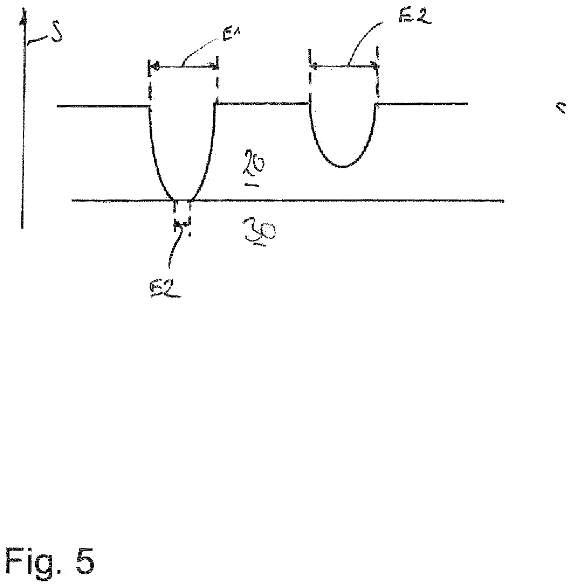

In **Figur 5** sind Schnittansichten durch zwei verschieden Formen von Materialschwächungen 25 dargestellt. Insbesondere ist es vorgesehen, dass die kuppelförmige Aussparungen an einer dem Keramikelement 30 abgewandten Außenseite der Rückseitenmetallisierung 20 eine erste Ausdehnung E1 aufweist. Vorzugsweise ist es vorgesehen, dass die erste Ausdehnung E1 für alle Materialschwächungen 25, insbesondere alle kuppelförmigen Aussparungen, im Wesentlichen identisch ist. Es ist auch vorstellbar, dass sich die Größe der ersten Ausdehnung E1 für die unterschiedlichen kuppelförmigen Aussparungen, die deckungsgleich angeordnet sind zu den Isolationsabschnitten 15, untereinander unterscheiden.

Vorzugsweise ist es vorgesehen, dass eine erste Ausdehnung E1 der Materialschwächung 25, insbesondere der kuppelförmigen Aussparung, kleiner ist als 1,5 mm, bevorzugt kleiner als 1,0 mm und besonders bevorzugt kleiner als 0,75 mm. Sofern die kuppelförmige Aussparung bis zum Keramikelement 30 reicht, ist es vorzugsweise vorgesehen, dass eine zweite Ausdehnung E2 der Materialschwächung 25 an der Außenseite der Rückseitenmetallisierung 20, die dem Keramikelement 30 zugewandt ist, kleiner ist als 1,3 mm, bevorzugt kleiner als 0,8 mm und besonders bevorzugt kleiner als 0,6 mm. Insbesondere nimmt ein Verhältnis der zweiten Ausdehnung E2 zur ersten Ausdehnung E1 einen Wert zwischen 0,6 und 0,95, bevorzugt zwischen 0,7 und 0,9 und besonders bevorzugt zwischen 0,75 und 0,85 an.

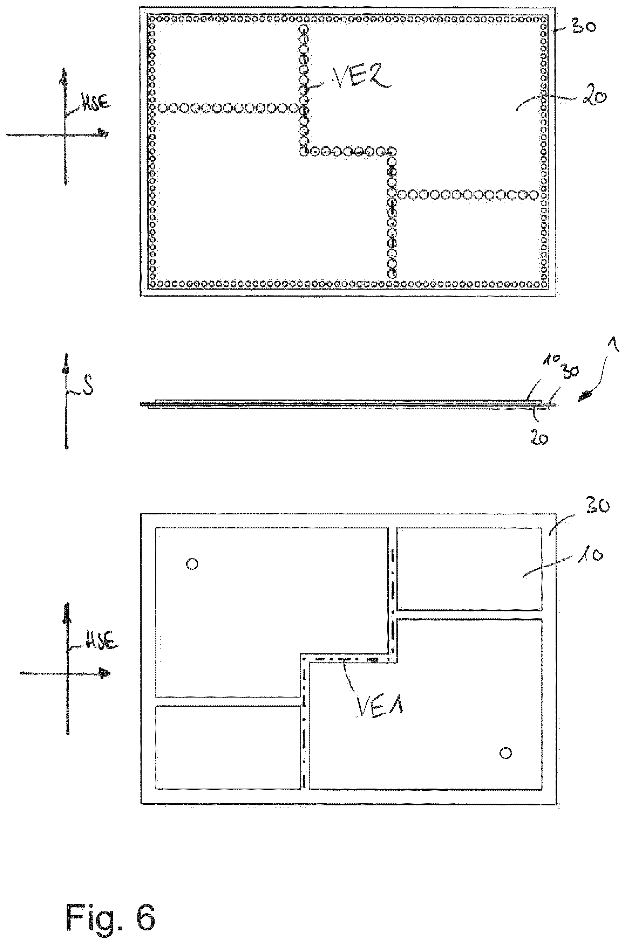

In **Figur 6** sind eine Bauteilmetallisierung 10 (unten) und eine Rückseitenmetallisierung 20 (oben) sowie eine Seitenansicht (Mitte) für ein Metall-Keramik-Substrat 1 gemäß einer vierten beispielhaften Ausführungsform dargestellt. Dabei unterscheidet sich die Ausführungsform der Figur 6 von derjenigen aus Figur 4 insbesondere dahingehend, dass der ersten Verlauf VE1 und der zweite Verlauf VE2, die zueinander deckungsgleich und jeweils in einem Zentralbereich der Bauteilmetallisierung 10 bzw. der Rückseitenmetallisierung 20 angeordnet sind, mehrere zueinander verwinkelte Teilabschnitte aufweisen. Dies ist erforderlich, um die gewünschte Musterung zur Ausbildung von Leiterbahnen oder Anschlusspads zu realisieren. Insbesondere ist der untere Figur ein erster Verlauf VE1 zu entnehmen, entlang der sich der Isolationsabschnitt 15 in der parallel zur Haupterstreckungsebene HSE verlaufenden Ebene erstreckt. In der hier gewählten Draufsicht erkennt man, dass zur Bildung eines Pullbacks das Keramikelement 30 in einer parallel zur Haupterstreckungsebene HSE verlaufenden Richtung gegenüber der Bauteilmetallisierung 10 vorsteht.

Im Wesentlichen ist es in dem Ausführungsbeispiel der Figur 6 vorgesehen, dass die Rückseitenmetallisierung 20 Materialschwächung 25 vorsieht, die deckungsgleich angeordnet sind zu dem ersten Verlauf VE1 des Isolationsabschnitts 15 auf der Bauteilmetallisierung 10 und weitere Materialschwächungen 26, die im Randbereich der Rückseitenmetallisierung 20 angeordnet sind. Man erkennt, dass die weiteren Materialschwächungen 26 im Randbereich nicht deckungsgleich zum gesamten Isolationsabschnitt 15 angeordnet ist.

In der Ausführungsform der Figur 6 ist es weiterhin vorgesehen, dass das Keramikelement 30 gegenüber der Rückseitenmetallisierung 20 in einer parallel zur Haupterstreckungsebene HSE verlaufenden Richtung weniger vorsteht als gegenüber der Bauteilmetallisierung 10. Dadurch wird auf der Bauteilseite BS mit dem vergrößerten Abstand zum Abschluss des Keramikelements 30 die Wahrscheinlichkeit für einen Überschlag reduziert, während auf der Rückseite RS durch den Randbereich der Rückseitenmetallisierung 20 eine Stabilisierung des Metall-Keramik-Substrats 1 unterstützt wird. Insbesondere ist es vorgesehen, dass die weitere Materialschwächung 26 im Randbereich der Rückseitenmetallisierung 20 in dem Bereich der Rückseitenmetallisierung 20 angeordnet ist, der in einer parallel zur Haupterstreckungsebene HSE verlaufenden Richtung gegenüber der Bauteilmetallisierung 10 vorsteht. In der Seitenansicht erkennt man, dass die Rückseitenmetallisierung 20 in seiner Ausdehnung in der Haupterstreckungsebene HSE größer ist als die Bauteilmetallisierung 10 und in einer parallel zur Haupterstreckungsebene HSE verlaufenden Richtung gegenüber der Bauteilmetallisierung 10 vorsteht.

Ferner ist es vorstellbar (nicht dargestellt), dass der zweite Verlauf VE2 der Materialschwächungen 25 vollständig deckungsgleich angeordnet ist zu dem Isolationsabschnitt 15, aber der zweite Verlauf VE2 Teilabschnitte umfasst, in denen von einer Materialschwächung 25 abgesehen wird. Somit ist der erste Verlauf VE1 nicht vollständig deckungsgleich zu dem zweiten Verlauf VE2, da es Teilbereiche des ersten Verlaufs VE1 gibt, für die auf der Rückseitenmetallisierung 20 keine Materialschwächung 25 vorgesehen ist. Dies ist insbesondere für solche Bereiche sinnvoll, in denen eine hohe Dichte an Isolationsgräben bzw. Isolationsabschnitten 15 vorgesehen ist, womit das Einbringen von entsprechenden Materialschwächungen 25 an der Rückseite RS zu einer entsprechenden Destabilisierung des Metall-Keramik-Substrats 1 führen würde.

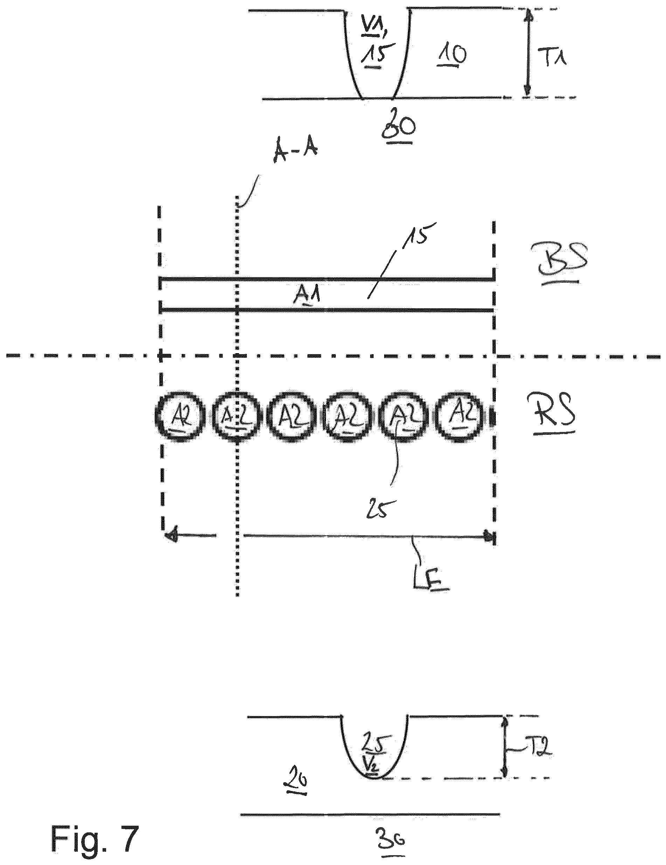

In **Figur 7** ist schematisch ein Vergleich zwischen einer dem Isolationsabschnitt 15 zugeordneten Aussparung und einer einer Materialschwächung 25 zugeordneten Aussparung für ein Metall-Keramik-Substrat 1 dargestellt. Mit anderen Worten: im mittleren Bereich der Figur 7 werden jeweils Draufsichten auf die Bauteilseite BS und auf die Rückseite RS dargestellt, wodurch eine erste Fläche A1 für die Aussparung des Isolationsabschnitts 15 zu erkennen ist, sowie mehrere Materialschwächungen 25 in Form von kuppelförmigen Aussparungen, die in der Draufsicht auf die Rückseite RS eine Aneinanderreihung von beispielswiese in der Summe gleich großen zweiten Flächen A2 bildet.

Entlang der ebenfalls hier eingefügten Schnittlinie AA ist zudem eine Schnittsicht durch die Bauteilmetallisierung (oben) und die Rückseitenmetallisierung (unten) dargestellt. Die Aussparung, die dem Isolationsabschnitt 15 auf der Bauteilseite BS zugeordnet ist, weist dabei eine erste Tiefe T1 auf, während die als kuppelförmige Aussparung ausgebildete Materialschwächung 25 eine zweite Tiefe T2 aufweist. Für eine möglichst hohe Symmetrie ist es vorgesehen, dass für eine festgelegte Längeneinheit LE ein erstes Volumen V1 der einen oder der mehreren Aussparungen zur Bildung des Isolationsabschnitts 15 in seiner Größe einem zweiten Volumen V2 entspricht, das die Aussparung oder die mehreren Aussparungen in der Rückseitenmetallisierung 10 pro Längeneinheit LE in einem dem Isolationsabschnitt 15 gegenüberliegenden Bereich in der Rückseitenmetallisierung 20 einnimmt. Die Längeneinheit LE wird bevorzugt durch den ersten Abstand AB1 zwischen zwei benachbarten Materialschwächungen 25 ausgebildet oder erstreckt sich über 1 cm, bevorzugt 2 cm und besonders bevorzugt 2,5 cm. Dabei ist es insbesondere vorgesehen, dass trotz der gleichen Größe der Volumina die Formen des ersten Volumens V1 und des zweiten Volumens V2 unterschiedlich sind. Beispielsweise ist der Isolationsabschnitt 15 durch eine durchgehende Aussparung gebildet, während die Materialschwächungen 25 auf der Rückseite RS auf kuppelförmige Aussparungen gebildet sind. Dadurch entspricht beispielsweise die zweite Tiefe T2 nicht der ersten Tiefe T1 und die entlang des ersten Verlaus VE1 und/oder zweiten Verlaufs VE2 bemessene Länge der Aussparung, die dem Isolationsabschnitt 15 zugeordnet ist entspricht nicht der entsprechenden Länge der Materialschwächung 25. Sofern die Aussparung in der Materialschwächung 25 bis zum Keramikelement 30 reicht, ist es bevorzugt vorgesehen, dass beispielsweise durch einen erhöhten Durchmesser für die Aussparung in der Rückseite RS eine erste Fläche A1 pro Längeneinheit LE in etwa der aufsummierten zweiten Fläche A2 in der Rückseite RS entspricht. Um die unterschiedlichen Formen der Materialschwächung 25 gegenüber der Aussparung zur Bildung des Isolationsabschnitts 15 Rechnung zu tragen, kann beispielsweise ein Durchmesser, d. h. eine zweite Breite B2, einer kuppelförmigen Aussparung größer gewählt werden als eine entsprechende erste Breite B1 des dazugehörigen Isolationsabschnitts 15. Dies erweist sich insbesondere deswegen als vorteilhaft, weil dadurch mehr Material auf der Rückseite RS erhalten bleibt, wodurch die Stabilität des gesamten Metall-Keramik-Substrats 1, insbesondere im Bereich des Isolationsabschnitts 15 erhöht bleibt. Gleichzeitig wird allerdings vermieden, dass die Symmetrie reduziert wird, was ein Durchbiegen wiederrum insbesondere im Betrieb des Metall-Keramik-Substrats 1 bedingen könnte.

Darüber hinaus ist es möglich, durch eine entsprechende erste Tiefen T1 und/oder zweite Tiefen T2 das erste Volumen V1 und/oder zweite Volumen V2 derart einzustellen, dass das erste Volumen V1 und das zweite Volumen V2 einander im Wesentlichen entsprechen.

Dabei versteht der Fachmann unter "im Wesentlichen", dass Abweichungen von weniger als 10%, bevorzugt von weniger als 5% und besonders bevorzugt von weniger als 2,5% der relevanten Größe bzw. vom Mittelwert der zu vergleichenden Werte zu erwarten sind.

### Bezugszeichen:

- 1: Metall-Keramik-Substrat
- 10: Bauteilmetallisierung
- 11: erster Metallabschnitt
- 12: zweiter Metallabschnitt
- 13: dritter Metallabschnitt
- 15: Isolationsabschnitt
- 20: Rückseitenmetallisierung
- 25: Materialschwächung
- 26: weitere Materialschwächung
- 30: Keramikelement
- 40: Restmetallisierung
- S: Stapelrichtung
- BS: Bauteilseite
- RS: Rückseite
- HSE: Haupterstreckungsebene
- R1: erste Richtung
- B1: erste Breite
- B2: zweite Breite
- D1: erste Dicke
- D2: zweite Dicke
- D3: dritte Dicke
- D4: vierte Dicke
- V1: erstes Volumen
- V2: zweites Volumen
- VE1: erster Verlauf
- VE2: zweiter Verlauf
- AB1: erster Abstand
- T1: erste Tiefe
- T2: zweite Tiefe
- E1: erste Ausdehnung
- E2: zweite Ausdehnung

## Patentansprüche

1. Metall-Keramik-Substrat (1), das als Leiterplatte zum Befestigen von elektrischen Bauteilen vorgesehen ist, umfassend:
- eine Bauteilmetallisierung (10) und eine Rückseitenmetallisierung (20) und
- ein Keramikelement (30), das entlang einer Stapelrichtung (S) zwischen der Bauteilmetallisierung (10) und der Rückseitenmetallisierung (20) angeordnet ist,
wobei die Bauteilmetallisierung (10) einen ersten Metallabschnitt (11) und einen zweiten Metallabschnitt (12) aufweist, wobei der erste Metallabschnitt (11) und der zweite Metallabschnitt (12) durch einen Isolationsabschnitt (15) voneinander getrennt sind, und
wobei die Rückseitenmetallisierung (20) eine Materialschwächung (25), insbesondere eine Materialaussparung, aufweist, die in Stapelrichtung (S) gesehen zumindest bereichsweise deckungsgleich zum Isolationsabschnitt (15) angeordnet ist, **dadurch gekennzeichnet, dass** eine Mehrzahl von separierten Materialschwächungen (25) ausgebildet ist, wobei zwei benachbarte Materialschwächungen (25) in einem ersten Abstand zueinander angeordnet sind, der kleiner als 600 µm ist und eine von den Isolationsabschnitten eingenommene erste Gesamtfläche in der Bauteilmetallisierung größer ist als eine von der Materialschwächung eingenommene zweite Gesamtfläche in der Rückseitenmetallisierung, wobei ein Verhältnis der zweiten Gesamtfläche zur ersten Gesamtfläche einen Wert annimmt, der zwischen 0,6 und 0,9 liegt.

2. Metall-Keramik-Substrat (1) gemäß Anspruch 1, wobei die Materialschwächung (25) als kuppelförmige Aussparung ausgebildet ist.

3. Metall-Keramik-Substrat (1) gemäß einem der vorhergehenden Ansprüche, wobei der Isolationsabschnitt (15) in der Bauteilmetallisierung (10) in einer parallel zur Haupterstreckungsebene (HSE) verlaufenden Ebene einem ersten Verlauf (VE1) und die Materialschwächung (25) oder mehrere Materialschwächungen (25) in der Rückseitenmetallisierung (20) in einer parallel zur Haupterstreckungsebene (HSE) verlaufenden Ebene einem zweite Verlauf (VE2) folgen, wobei vorzugsweise der zweite Verlauf (VE2) in Stapelrichtung (S) deckungsgleich zum ersten Verlauf (VE1) angeordnet ist.

4. Metall-Keramik-Substrat (1) gemäß Anspruch 3, wobei der zweite Verlauf (VE2) der Materialschwächung (25) oder der Materialschwächungen (25) durch eine Aneinanderreihung von Materialschwächungen (25), beispielsweise in Form einer Lochreihe, ausgebildet ist und/oder entlang des zweiten Verlaufs (VE2) zwischen zwei Materialschwächungen (25) einen Stabilisierungsbereich aufweist.

5. Metall-Keramik-Substrat (1) gemäß einem der vorhergehenden Ansprüche, wobei eine weitere Materialschwächung (26) vorgesehen ist, die in der Rückseitenmetallisierung (20) in einem Randbereich der Rückseitenmetallisierung (20) eingelassen ist und insbesondere unabhängig von einem Isolationsabschnitt (15) in die Bauteilmetallisierung (10) eingelassen ist.

6. Metall-Keramik-Substrat (1) gemäß einem der vorhergehenden Ansprüche, wobei die als Aussparung ausgebildete Materialschwächung (25) in der Rückseitenmetallisierung (20) bis zum Keramikelement (30) reicht.

7. Metall-Keramik-Substrat (1) gemäß Anspruch 5, wobei zwischen der als Aussparung ausgebildeten weiteren Materialschwächung (26) und dem Keramikelement (30) eine Restmetallisierung (40) ausgebildet ist.

8. Metall-Keramik-Substrat (1) gemäß Anspruch 3, wobei ein Verhältnis von Abschnitten, bei denen der erste Verlauf (VE1) und der zweite Verlauf (VE2) in Stapelrichtung (S) gesehen nicht deckungsgleich verlaufen, zu Abschnitten, bei denen der erste Verlauf (VE1) und der zweite Verlauf (VE2) in Stapelrichtung (S) gesehen deckungsgleich zueinander verlaufen, ein Wert annimmt, der kleiner ist als 1, bevorzugt kleiner als 0,5 und besonders bevorzugt kleiner als 0,2.

9. Metall-Keramik-Substrat (1) gemäß Anspruch 3, wobei pro Längeneinheit (LE) entlang des ersten Verlaufs (VE1) und/oder zweiten Verlaufs (VE2) der Isolationsabschnitt (15) ein erstes Volumen (V1) annimmt und die Materialschwächung (25) oder die Materialschwächungen in der Rückseitenmetallisierung (20) ein zweites Volumen (V2) annimmt bzw. annehmen, wobei das erste Volumen (V1) und das zweite Volumen (V2) in Hinblick auf ihre absolute Größe im Wesentlichen gleich sind und in Hinblick auf ihre geometrische Formen unterschiedlich sind.

10. Metall-Keramik-Substrat (1), das als Leiterplatte zum Befestigen von elektrischen Bauteilen vorgesehen ist, umfassend:
- eine Bauteilmetallisierung (10) und eine Rückseitenmetallisierung (20) und
- ein Keramikelement (30), das entlang einer Stapelrichtung (S) zwischen der Bauteilmetallisierung (10) und der Rückseitenmetallisierung (20) angeordnet ist,
wobei die Bauteilmetallisierung (10) einen ersten Metallabschnitt (11) und einen zweiten Metallabschnitt (12) aufweist, wobei der erste Metallabschnitt (11) und der zweite Metallabschnitt (12) durch einen Isolationsabschnitt (15) voneinander getrennt sind und/oder auf dem ersten Metallabschnitt ein Anschlussbereich für ein elektrisches Bauteil vorgesehen ist, und
wobei die Rückseitenmetallisierung (20) eine Materialschwächung (25) in Form einer Materialaussparung aufweist, die in Stapelrichtung (S) gesehen zumindest bereichsweise deckungsgleich zum Anschlussbereich angeordnet ist, **dadurch gekennzeichnet, dass** eine Mehrzahl von separierten Materialschwächungen (25) ausgebildet ist, wobei die Rückseitenmetallisierung sowohl Materialaussparungen aufweist, die deckungsgleich zu den Isolationsabschnitten sind, als auch Materialaussparungen, die deckungsgleich zu dem Anschlussbereich sind..

11. Verfahren zur Herstellung eines Metall-Keramik-Substrats (1) gemäß einem der vorhergehenden Ansprüche, umfassend:
- Bereitstellen einer Bauteilmetallisierung (10) und einer Rückseitenmetallisierung (30) sowie eines Keramikelements (20),
- Anbinden der Bauteilmetallisierung (10) und der Rückseitenmetallisierung (30) an das Keramikelement (20), wobei das Keramikelement (20) entlang einer Stapelrichtung (S) zwischen der Bauteilmetallisierung (10) und der Rückseitenmetallisierung (20) angeordnet wird,
- Strukturieren der Bauteilmetallisierung (10) durch Realisieren von Isolationsabschnitten (15) und
- Realisieren einer Materialschwächungen (25) in die Rückseitenmetallisierung (20), wobei die Materialschwächung (25) in Stapelrichtung (S) gesehen deckungsgleich zum Isolationsabschnitt (15) und/oder einem Anschlussbereich des ersten Metallabschnitts angeordnet wird.

## Claims

1. A metal-ceramic substrate (1) provided as a printed circuit board for mounting electrical components, comprising:
- a component metallisation (10) and a backside metallisation (20), and
- a ceramic element (30) arranged between the component metallisation (10) and the backside metallisation (20) along a stacking direction (S),
wherein the component metallisation (10) has a first metal section (11) and a second metal section (12), wherein the first metal section (11) and the second metal section (12) are separated from each other by an isolation section (15), and
wherein the backside metallisation (20) has a material weakening (25), in particular a material recess, which, viewed in the stacking direction (S), is arranged at least zonally congruently with the isolation section (15), **characterized in that** a plurality of separated material weakenings (25) are formed, wherein two adjacent material weakenings (25) are arranged at a first distance from each other which is less than 600 µm, and a first total area occupied by the isolation sections in the component metallisation is greater than a second total area occupied by the material weakening in the backside metallisation, wherein a ratio of the second total area to the first total area assumes a value which lies between 0.6 and 0.9.

2. The metal-ceramic substrate (1) according to claim 1, wherein the material weakening (25) is formed as a dome-shaped recess.

3. The metal-ceramic substrate (1) according to one of the preceding claims, wherein the isolation section (15) in the component metallisation (10) in a plane parallel to the main extension plane (HSE) has a first course (VE1) and the material weakening (25) or several material weakenings (25) in the backside metallisation (20) follow a second course (VE2) in a plane parallel to the main extension plane (HSE), wherein the second course (VE2) is preferably arranged congruently with the first course (VE1) in the stacking direction (S).

4. The metal-ceramic substrate (1) according to claim 3, wherein the second course (VE2) of the material weakening (25) or the material weakenings (25) is formed by a sequence of material weakenings (25), for example in the form of a row of holes, and/or has a stabilization region along the second course (VE2) between two material weakenings (25).

5. The metal-ceramic substrate (1) according to one of the preceding claims, wherein a further material weakening (26) is provided, which is embedded in the backside metallisation (20) in a peripheral region of the backside metallisation (20) and, in particular, is embedded in the component metallisation (10) independently of an isolation section (15).

6. The metal-ceramic substrate (1) according to one of the preceding claims, wherein the material weakening (25) formed as a recess extends in the backside metallisation (20) to the ceramic element (30).

7. The metal-ceramic substrate (1) according to claim 5, wherein a residual metallisation (40) is formed between the further material weakening (26) formed as a recess and the ceramic element (30).

8. The metal-ceramic substrate (1) according to claim 3, wherein a ratio of sections in which the first course (VE1) and the second course (VE2) are not congruent when viewed in the stacking direction (S) to sections in which the first course (VE1) and the second course (VE2) are congruent with each other when viewed in the stacking direction (S), have a value that is less than 1, more preferably less than 0.5, and most preferably less than 0.2.

9. The metal-ceramic substrate (1) according to claim 3, wherein per unit of length (LE) along the first course (VE1) and/or second course (VE2), the isolation section (15) attains a first volume (V1) and the material weakening (25) or the material weakenings in the backside metallisation (20) attains or attain a second volume (V2), wherein the first volume (V1) and the second volume (V2) are essentially equal in terms of their absolute size and are different in terms of their geometric forms.

10. A metal-ceramic substrate (1) provided as a printed circuit board for mounting electrical components, comprising:
- a component metallisation (10) and a backside metallisation (20), and
- a ceramic element (30) arranged between the component metallisation (10) and the backside metallisation (20) along a stacking direction (S),
wherein the component metallisation (10) has a first metal section (11) and a second metal section (12), wherein the first metal section (11) and the second metal section (12) are separated from each other by an isolation section (15) and/or a connection region for an electrical component is provided on the first metal section, and
wherein the backside metallisation (20) has a material weakening (25) in the form of a material recess which when viewed in the stacking direction (S), is arranged at least partially congruent with the connection region, **characterized in that** a plurality of separated material weakenings (25) are formed, wherein the backside metallisation has both material recesses that are congruent with the isolation sections and material recesses that are congruent with the connection region.

11. A method for manufacturing a metal-ceramic substrate (1) according to one of the preceding claims, comprising:
- providing a component metallisation (10) and a backside metallisation (30) as well as a ceramic element (20),
- bonding the component metallisation (10) and the backside metallisation (30) to the ceramic element (20), wherein the ceramic element (20) is arranged between the component metallisation (10) and the backside metallisation (20) along a stacking direction (S),
- structuring the component metallisation (10) by realising isolation sections (15) and
- creating material weakening (25) in the backside metallisation (20), wherein the material weakening (25) is arranged so as to be congruent with the isolation section (15) and/or a connection region of the first metal section when viewed in the stacking direction (S).

## Revendications

1. Substrat métal-céramique (1) destiné à servir de carte de circuit imprimé pour la fixation de composants électriques, comprenant :
- une métallisation côté composant (10) et une métallisation côté arrière (20) et
- un élément céramique (30) disposé entre la métallisation côté composant (10) et la métallisation côté arrière (20) selon une direction d'empilement (S),
la métallisation côté composant (10) comprenant une première partie métallique (11) et une deuxième partie métallique (12), la première partie métallique (11) et la deuxième partie métallique (12) étant séparées l'une de l'autre par une partie isolante (15), et
la métallisation côté arrière (20) présentant un affaiblissement de matériau (25), en particulier un évidement de matériau, qui, vu dans la direction d'empilement (S), est disposé de manière à coïncider au moins localement avec la partie isolante (15),
**caractérisé en ce qu'**il est prévu une pluralité d'affaiblissements de matériau séparés (25), sachant que deux affaiblissements de matériau voisins (25) sont disposés à une première distance l'un de l'autre qui est inférieure à 600 µm, et une première surface totale, occupée par les parties isolantes, dans la métallisation côté composant est supérieure à une deuxième surface totale, occupée par l'affaiblissement de matériau, dans la métallisation côté arrière, le rapport de la deuxième surface totale sur la première surface totale prenant une valeur comprise entre 0,6 et 0,9.

2. Substrat métal-céramique (1) selon la revendication 1,
dans lequel l'affaiblissement de matériau (25) est conçu comme un évidement en forme de dôme.

3. Substrat métal-céramique (1) selon l'une des revendications précédentes, dans lequel la partie isolante (15) dans la métallisation côté composant (10) suit un premier tracé (VE1) dans un plan parallèle au plan d'extension principal (HSE), et l'affaiblissement de matériau (25) ou plusieurs affaiblissements de matériau (25) dans la métallisation côté arrière (20) suivent un deuxième tracé (VE2) dans un plan parallèle au plan d'extension principal (HSE), de préférence, le deuxième tracé (VE2) étant disposé de manière à coïncider avec le premier tracé (VE1) dans la direction d'empilement (S).

4. Substrat métal-céramique (1) selon la revendication 3,
dans lequel le deuxième tracé (VE2) de l'affaiblissement de matériau (25) ou des affaiblissements de matériau (25) est formé par une juxtaposition d'affaiblissements de matériau (25), par exemple sous la forme d'une rangée de trous, et/ou présente une zone de stabilisation entre deux affaiblissements de matériau (25) le long du deuxième tracé (VE2).

5. Substrat métal-céramique (1) selon l'une des revendications précédentes, dans lequel est prévu un autre affaiblissement de matériau (26) qui est encastré dans la métallisation côté arrière (20) dans une zone marginale de la métallisation côté arrière (20) et qui est encastré dans la métallisation côté composant (10) en particulier indépendamment d'une partie isolante (15).

6. Substrat métal-céramique (1) selon l'une des revendications précédentes, dans lequel l'affaiblissement de matériau (25) conçu comme un évidement dans la métallisation côté arrière (20) s'étend jusqu'à l'élément céramique (30).

7. Substrat métal-céramique (1) selon la revendication 5,
dans lequel une métallisation résiduelle (40) est formée entre l'autre affaiblissement de matériau (26), conçu comme un évidement, et l'élément céramique (30).

8. Substrat métal-céramique (1) selon la revendication 3,
dans lequel le rapport des parties dans lesquelles le premier tracé (VE1) et le deuxième tracé (VE2), vus dans la direction d'empilement (S), ne s'étendent pas de manière à coïncider, sur les parties dans lesquelles le premier tracé (VE1) et le deuxième tracé (VE2), vus dans la direction d'empilement (S), s'étendent de manière à coïncider, prend une valeur inférieure à 1, de préférence inférieure à 0,5 et de manière particulièrement préférée inférieure à 0,2.

9. Substrat métal-céramique (1) selon la revendication 3,
dans lequel, par unité de longueur (LE) le long du premier tracé (VE1) et/ou du deuxième tracé (VE2), la partie isolante (15) prend un premier volume (V1), et l'affaiblissement de matériau (25) ou les affaiblissements de matériau dans la métallisation côté arrière (20) prend ou prennent un deuxième volume (V2), le premier volume (V1) et le deuxième volume (V2) étant sensiblement identiques en termes de taille absolue et étant différents en termes de formes géométriques.

10. Substrat métal-céramique (1) destiné à servir de carte de circuit imprimé pour la fixation de composants électriques, comprenant :
- une métallisation côté composant (10) et une métallisation côté arrière (20) et
- un élément céramique (30) disposé entre la métallisation côté composant (10) et la métallisation côté arrière (20) selon une direction d'empilement (S),
la métallisation côté composant (10) comprenant une première partie métallique (11) et une deuxième partie métallique (12), la première partie métallique (11) et la deuxième partie métallique (12) étant séparées l'une de l'autre par une partie isolante (15), et/ou une zone de connexion pour un composant électrique étant prévue sur la première partie métallique, et
la métallisation côté arrière (20) présentant un affaiblissement de matériau (25) sous la forme d'un évidement de matériau, qui, vu dans la direction d'empilement (S), est disposé de manière à coïncider au moins localement avec la zone de connexion,
**caractérisé en ce qu'**il est prévu une pluralité d'affaiblissements de matériau séparés (25), la métallisation côté arrière présentant à la fois des évidements de matériau qui coïncident avec les parties isolantes et des évidements de matériau qui coïncident avec la zone de connexion.

11. Procédé de fabrication d'un substrat métal-céramique (1) selon l'une des revendications précédentes, consistant à :
- fournir une métallisation côté composant (10) et une métallisation côté arrière (30) ainsi qu'un élément céramique (20),
- relier la métallisation côté composant (10) et la métallisation côté arrière (30) à l'élément céramique (20), l'élément céramique (20) étant disposé entre la métallisation côté composant (10) et la métallisation côté arrière (20) selon une direction d'empilement (S),
- structurer la métallisation côté composant (10) en réalisant des parties isolantes (15), et
- réaliser un affaiblissement de matériau (25) dans la métallisation côté arrière (20), l'affaiblissement de matériau (25), vu dans la direction d'empilement (S), étant disposé de manière à coïncider avec la partie isolante (15) et/ou avec une zone de connexion de la première partie métallique.
